# EUROPEAN PATENT APPLICATION

(11) **EP 2 682 441 A1**
(43) Date of publication of application: **08.01.2014**
(21) Application number: 12175333.9
(22) Date of filing: 06.07.2012
(51) Int. Cl.: C09G 1/02, H01L 21/321

(54) **A chemical mechanical polishing (CMP) composition comprising a non-ionic surfactant and an aromatic compound comprising at least one acid group**

(71) Applicant: BASF SE, 67056 Ludwigshafen (DE)
(72) Inventor: Reichardt, Robert Dr., 68161 Mannheim (DE); Li, Yuzhuo Prof. Dr., "deceased" (US); Gao, Ning, 13676 Potsdam, NY (US); Lauter, Michael Dr., 68163 Mannheim (DE)

(57) **Abstract**

A chemical mechanical polishing (CMP) composition (Q) comprising
(A) inorganic particles, organic particles, or a mixture or composite thereof,
(B) a non-ionic surfactant,
(C) an aromatic compound comprising at least one acid group (Y), or a salt thereof, and
(M) an aqueous medium.

## Description

### Field of the Invention

This invention essentially relates to a chemical mechanical polishing (abbreviated as CMP in the following) CMP composition comprising a non-ionic surfactant and an aromatic compound comprising at least one acid group.

### Description of the Prior Art

In the semiconductor industry, chemical mechanical polishing is a well-known technology applied in fabricating advanced photonic, microelectromechanical, and microelectronic materials and devices, such as semiconductor wafers.

During the fabrication of materials and devices used in the semiconductor industry, CMP is employed to planarize metal and/or oxide surfaces. CMP utilizes the interplay of chemical and mechanical action to achieve the planarity of the to-be-polished surfaces. Chemical action is provided by a chemical composition, also referred to as CMP composition or CMP slurry. Mechanical action is usually carried out by a polishing pad which is typically pressed onto the to-be-polished surface and mounted on a moving platen. The movement of the platen is usually linear, rotational or orbital.

In a typical CMP process step, a rotating wafer holder brings the to-be-polished wafer in contact with a polishing pad. The CMP composition is usually applied between the to-be-polished wafer and the polishing pad.

In the state of the art, CMP compositions comprising a surfactant and an aromatic compound comprising at least one acid group are known and described, for instance, in the following references.

US 2009/032765 A1 discloses an aqueous slurry useful for chemical mechanical polishing a semiconductor substrate having copper interconnects comprising by weight percent: 0 to 25 oxidizing agent, 0.1 to 30 abrasive particles, 0.001 to 5 benzenecarboxylic acid, 0.00002 to 5 multi-component surfactant, the multi-component surfactant having a hydrophobic tail, a nonionic hydrophilic portion and an anionic hydrophilic portion, the hydrophobic tail having 6 to 30 carbon atoms and the nonionic hydrophilic portion having 10 to 300 carbon atoms, 0.001 to 10 inhibitor for decreasing static etch of the copper interconnects, 0 to 5 phosphorus-containing compound for increasing removal rate of the copper interconnects, 0 to 10 complexing agent formed during polishing and balance water. Example Slurries 1 to 7 having a pH of 8 or 9 and comprising - inter alia -
(a) benzene-1,2,4-tricarboxylic acid,
(b) Disponil™ FES surfactant (a fatty alcohol polyglycol ether sulphate, Na-salt, i.e. an anionic surfactant) manufactured by Cognis Chemical Group as a surfactant,
(c) benzotriazole,
(d) silica as abrasive, and
(e) hydrogen peroxide as oxidizing agent
were also disclosed.

US 2009/311864 A1 discloses a polishing slurry used in chemical mechanical polishing of a barrier layer and an interlayer dielectric film in a semiconductor integrated circuit, the polishing slurry comprising: an abrasive; an oxidizer; an anticorrosive; an acid; a surfactant; and an inclusion compound, wherein the polishing slurry has a pH of less than 5. Examples EX 17 and EX comprising
- colloidal silica as the abrasive,
- 1-[N,N-bis(hydroxyethyl)aminomethyl]benzotriazole (HEABTA),
- 2,5-furane-dicarboxylic acid,
- alkyl diphenyl ether disulfonic acid as an anionic surfactant,
- a specific di-quaternary cation (A17 and A27),
- hydrogen peroxide as the oxidizer, and
- cyclodextrin as the inclusion compound
were also disclosed.

### Objects of the invention

One of the objects of the present invention was to provide a CMP composition and a CMP process appropriate for the chemical-mechanical polishing of substrates used in the semiconductor industry, particularly substrates comprising
(1) copper, and/or
(2) tantalum, tantalum nitride, titanium, titanium nitride, ruthenium, cobalt, or alloys thereof,
and showing an improved polishing performance, especially
(i) a high material removal rate (MRR) of the substrate to be preferably polished, for example tantalum nitride,
(ii) a low material removal rate (MRR) of the substrate not to be preferably polished, for example copper and/or low k material,
(iii) safe handling and reduction of hazardous by-products to a minimum, or
(iv) the combination of (i), (ii), (iii).

Furthermore, the CMP composition should be a stable formulation or dispersion where no phase separation should occur. Moreover, a CMP process was sought that is easy to apply and requires as few steps as possible.

As far as barrier layers and low-k or ultra-low-k materials are present in the semiconductor substrate used, the CMP composition of the invention should preferably remove the barrier layers and maintain the integrity of the low-k and ultra-low-k materials, i.e., it should have a particularly high selectivity of barrier layer over low-k or ultra-low-k materials with regard to the MRRs. Particularly, as far as copper layers, barrier layers and low-k or ultra-low-k materials are present in the substrate to be polished, the CMP composition of the invention should show the combination of as many as possible of the following properties: (a) high MRR of barrier layer, (b) low MRR of copper layer, (c) low MRR of low-k or ultra-low-k materials, (d) high selectivity of barrier layer over copper layer with regard to MRR, (e) high selectivity of barrier layer over low-k and ultra-low-k materials with regard to MRR. Most particularly, as far as copper layers, tantalum or tantalum nitride layers and low-k or ultra-low-k materials are present in the substrate to be polished, the CMP composition of the invention should show the combination of as many as possible of the following properties: (a') high MRR of tantalum or tantalum nitride, (b') low MRR of copper layer, (c') low MRR of low-k or ultra-low-k materials, (d') high selectivity of tantalum or tantalum nitride over copper with regard to MRR, and (e') high selectivity of tantalum nitride over low-k or ultra-low-k materials with regard to MRR. Furthermore, the CMP composition of the invention should show a long shelf life, while high MRR of barrier layer is maintained.

### Summary of the invention

Accordingly, a chemical mechanical polishing (CMP) composition (Q) was found which comprises
(A) inorganic particles, organic particles, or a mixture or composite thereof,
(B) a non-ionic surfactant,
(C) an aromatic compound comprising at least one acid group (Y), or a salt thereof, and
(M) an aqueous medium.

In addition, a process for the manufacture of a semiconductor device comprising the chemical mechanical polishing of a substrate in the presence of the CMP composition (Q) was found, which fulfills the objects of the invention.

Moreover, the use of the CMP composition (Q) for polishing substrates which are used in the semiconductor industry has been found, which fulfills the objects of the invention.

Preferred embodiments are explained in the claims and the specification. It is understood that combinations of preferred embodiments are within the scope of the present invention.

A process for the manufacture of semiconductor devices comprising the chemical mechanical polishing of a substrate in the presence of the CMP composition (Q) was found. A further process of the invention is a process for chemical mechanical polishing of a substrate (S) used in the semiconductor industry in the presence of the CMP composition (Q). The CMP composition (Q) is used for chemical-mechanical polishing of a substrate (S) used in the semiconductor industry. Said substrate (S) is preferably a substrate comprising
(i) copper, and/or
(ii) tantalum, tantalum nitride, titanium, titanium nitride, ruthenium, cobalt, or alloys thereof.

Said substrate (S) is more preferably a substrate comprising
(i) copper, and
(ii) tantalum, tantalum nitride, titanium, titanium nitride, ruthenium, cobalt, or alloys thereof, and
(iii) a low k material.

Said substrate (S) is most preferably a substrate comprising
(i) copper, and
(ii) tantalum, or tantalum nitride, and
(iii) a low k material.

A low-k material is a material having a k value (dielectric constant) of less than 3.5, preferably less than 3.0, more preferably less than 2.7. An ultra-low-k material Is a material having a k value (dielectric constant) of less than 2.4.

The CMP composition (Q) comprises the components (A), (B), (C), (M) and optionally further components as described below.

The CMP composition (Q) comprises inorganic particles, organic particles, or a mixture or composite thereof (A). (A) can be
- of one type of inorganic particles,
- a mixture or composite of different types of inorganic particles,
- of one type of organic particles,
- a mixture or composite of different types of organic particles, or
- a mixture or composite of one or more types of inorganic particles and one or more types of organic particles.

A composite is a composite particle comprising two or more types of particles in such a way that they are mechanically, chemically or in another way bound to each other. An example for a composite is a core-shell particle comprising one type of particle in the outer sphere (shell) and another type of particle in the inner sphere (core).

Generally, the particles (A) can be contained in varying amounts in the CMP composition (Q). Preferably, the amount of (A) is not more than 10 wt.% (wt.% stands for "percent by weight"), more preferably not more than 7 wt.%, most preferably not more than 5 wt.%, particularly not more than 3 wt.%, for example not more than 2.2 wt.%, based on the total weight of the composition (Q). Preferably, the amount of (A) is at least 0.002 wt.%, more preferably at least 0.01 wt.%, most preferably at least 0.08 wt.%, particularly at least 0.5 wt.%, for example at least 1 wt.%, based on the total weight of the composition (Q).

Generally, the particles (A) can be contained in varying particle size distributions. The particle size distributions of the particles (A) can be monomodal or multimodal. In case of multimodal particle size distributions, bimodal is often preferred. In order to have an easily reproducible property profile and easily reproducible conditions during the CMP process of the invention, a monomodal particle size distribution is preferred for (A). It is most preferred for (A) to have a monomodal particle size distribution.

The mean particle size of the particles (A) can vary within a wide range. The mean particle size is the d₅₀ value of the particle size distribution of (A) in the aqueous medium (M) and can be determined using dynamic light scattering techniques. Then, the d₅₀ values are calculated under the assumption that particles are essentially spherical. The width of the mean particle size distribution is the distance (given in units of the x-axis) between the two intersection points, where the particle size distribution curve crosses the 50% height of the relative particle counts, wherein the height of the maximal particle counts is standardized as 100% height.

Preferably, the mean particle size of the particles (A) is in the range of from 5 to 500 nm, more preferably in the range of from 10 to 400 nm, most preferably in the range of from 20 to 300 nm, in particular in the range of from 30 to 160 nm, for example in the range of from 35 to 135 nm, as measured with dynamic light scattering techniques using instruments such as High Performance Particle Sizer (HPPS) from Malvern Instruments, Ltd. or Horiba LB550.

The particles (A) can be of various shapes. Thereby, the particles (A) may be of one or essentially only one type of shape. However, it is also possible that the particles (A) have different shapes. For instance, two types of differently shaped particles (A) may be present. For example, (A) can have the shape of cubes, cubes with chamfered edges, octahedrons, icosahedrons, cocoons, nodules or spheres with or without protrusions or indentations. Preferably, they are spherical with no or only very few protrusions or indentations. According to another embodiment, they are preferably cocoon-shaped. Cocoon-shaped particles are particles with a minor axis of from 10 to 200 nm - as measured with dynamic light scattering techniques - and a ratio of major/minor axis of 1.4 to 2.2, more preferably of 1.6 to 2.0. For example, cocoon-shaped particles are FUSO PL-3 manufactured by Fuso Chemical Corporation having an average primary particle size (d1) of 35 nm and an average secondary particle size (d2) of 70 nm.

The chemical nature of particles (A) is not particularly limited. (A) may be of the same chemical nature or a mixture or composite of particles of different chemical nature. As a rule, particles (A) of the same chemical nature are preferred. Generally, (A) can be
- inorganic particles such as a metal, a metal oxide or carbide, including a metalloid, a metalloid oxide or carbide, or
- organic particles such as polymer particles,
- a mixture or composite of inorganic and organic particles.

Particles (A) are
- preferably inorganic particles, or a mixture or composite thereof,
- more preferably oxides and carbides of metals or metalloids, or a mixture or composite thereof,
- most preferably alumina, ceria, copper oxide, iron oxide, nickel oxide, manganese oxide, silica, silicon nitride, silicon carbide, tin oxide, titania, titanium carbide, tungsten oxide, yttrium oxide, zirconia, or a mixture or composites thereof,
- particularly preferably alumina, ceria, silica, titania, zirconia, or a mixture or composite thereof,
- in particular silica particles,
- for instance cocoon-shaped silica particles,
- for example colloidal silica particles.

Typically, colloidal silica particles are produced by a wet precipitation process.

In another embodiment in which (A) are organic particles, or a mixture or composite of inorganic and organic particles, polymer particles are preferred as organic particles.

According to the invention, the CMP composition (Q) comprises a non-ionic surfactant (B). Generally, a surfactant used in a CMP composition is a surface-active compound which decreases the surface tension of a liquid, the interfacial tension between two liquids, or that between a liquid and a solid. In general, any non-ionic surfactant (B) can be used.

The non-ionic surfactant (B) is preferably water-soluble and/or water-dispersible, more preferably water-soluble. "Water-soluble" means that the relevant component or ingredient of the composition of the invention can be dissolved in the aqueous phase on the molecular level. "Water-dispersible" means that the relevant component or ingredient of the composition of the invention can be dispersed in the aqueous phase and forms a stable emulsion or suspension.

The non-ionic surfactant (B) is preferably an amphiphilic non-ionic surfactant, i.e. a surfactant which comprises at least one hydrophobic group (b1) and at least one hydrophilic group (b2). This means that the nonionic surfactant (B) can comprise more than one hydrophobic group (b1), e.g., 2, 3 or more groups (b1), which are separated from each other by at least one hydrophilic group (b2) as hereinbelow described. This also means that the nonionic surfactant (B) can comprise more than one hydrophilic group (b2), e.g., 2, 3 or more groups (b2) which are separated from each other by hydrophobic groups (b1) as hereinbelow described.

Therefore, the nonionic surfactant (B) can have different blocklike general structures. Examples of such general blocklike structures are:
- b1-b2,
- b1-b2-b1,
- b2-b1-b2,
- b2-b1-b2-b1,
- b1-b2-b1-b2-b1, and
- b2-b1-b2-b1-b2.

The non-ionic surfactant (B) is more preferably an amphiphilic non-ionic surfactant comprising a polyoxyalkylene group.

The hydrophobic group (b1) is preferably an alkyl group, more preferably an alkyl group having 4 to 40, most preferably 5 to 20, particularly preferably 7 to 18, in particular 10 to 16, for example 11 to 14 carbon atoms.

The hydrophilic group (b2) is preferably a polyoxyalkylene group. Said polyoxyalkylene groups can be oligomeric or polymeric. More preferably, the hydrophilic group (b2) is a hydrophilic group selected from the group consisting of polyoxyalkylene groups comprising
(b21) oxyalkylene monomer units, and
(b22) oxyalkylene monomer units other than oxyethylene monomer units,
said monomer units (b21) being not identical to monomer units (b22), and said polyoxyalkylene group of (b2) containing the monomer units (b21) and (b22) in random, alternating, gradient and/or block-like distribution.

Most preferably, the hydrophilic group (b2) is a hydrophilic group selected from the group consisting of polyoxyalkylene groups comprising
(b21) oxyethylene monomer units, and
(b22) oxyalkylene monomer units other than oxyethylene monomer units,
said polyoxyalkylene group of (b2) containing the monomer units (b21) and (b22) in random, alternating, gradient and/or block-like distribution.

Preferably, the oxyalkylene monomer units other than oxyethylene monomer units (b22) are substituted oxyalkylene monomer units wherein the substituents are selected from the group consisting of alkyl, cycloalkyl, aryl, alkyl-cycloalkyl, alkyl-aryl, cycloalkyl-aryl and alkyl-cycloalkyl-aryl groups. The oxyalkylene monomer units other than oxyethylene monomer units (b22) are
- more preferably derived from substituted oxiranes (X) wherein the substituents are selected from the group consisting of alkyl, cycloalkyl, aryl, alkyl-cycloalkyl, alkyl-aryl, cycloalkyl-aryl and alkyl-cycloalkyl-aryl groups,
- most preferably derived from alkyl-substituted oxiranes (X),
- particularly preferably derived from substituted oxiranes (X) wherein the substituents are selected from the group consisting of alkyl groups having 1 to 10 carbon atoms,
- for example derived from methyl oxirane (propyleneoxide) and/or ethyl oxirane (butylene oxide).

The substituents of the substituted oxiranes (X) themselves can also carry inert substituents, i.e., substituents which do not adversely affect the copolymerization of the oxiranes (X) and the surface activity of the non-ionic surfactants (B). Examples of such inert substituents are fluorine and chlorine atoms, nitro groups and nitrile groups. If such inert substituents are present, they are used in such amounts that they do not adversely affect the hydrophilic-hydrophobic balance of the non-ionic surfactant (B). Preferably, the substituents of the substituted oxiranes (X) do not carry such inert substituents.

The substituents of the substituted oxiranes (X) are preferably selected from the group consisting of alkyl groups having 1 to 10 carbon atoms, cycloalkyl groups having 5 to 10 carbon atoms in spirocyclic, exocyclic and/or annealed configuration, aryl groups having 6 to 10 carbon atoms, alkyl-cycloalkyl groups having 6 to 20 carbon atoms, alkyl-aryl groups having 7 to 20 carbon atoms, cycloalkyl-arylgroup 11 to 20 carbon atoms, and alkyl-cycloalkyl-aryl groups having 12 to 30 carbon atoms. Most preferably, the substituents of the substituted oxiranes (X) are selected from the group consisting of alkyl groups having 1 to 10 carbon atoms. Particularly, the substituents of the substituted oxiranes (X) are selected from the group consisting of alkyl groups having 1 to 6 carbon atoms.

Examples for the most preferred substituted oxiranes (X) are methyl oxirane (propyleneoxide) and/or ethyl oxirane (butylene oxide), particularly methyl oxirane.

Most preferably, the hydrophilic group (b2) consists of the monomer units (b21) and (b22).

In another embodiment, the hydrophilic group (b2) is preferably a polyoxyethylene, polyoxypropylene or polyoxybutylene group, more preferably a polyoxyethylene group.

In the embodiments where the hydrophilic group (b2) comprises or consists of the monomer units (b21) and (b22), the polyoxyalkylene group - acting as hydrophilic group (b2) - contains the monomer units (b21) and (b22) in random, alternating, gradient and/or blocklike distribution. This means, that one hydrophilic group (b2) can have only one type of distribution, i.e.,
- random: ...-b21-b21-b22-b21-b22-b22-b22-b21-b22-...;
- alternating: ...-b21-b22-b21-b22-b21-...;
- gradient: ... b21-b21-b21-b22-b21-b21-b22-b22-b21-b22-b22-b22-... ; or
- blocklike: ...-b21-b21-b21-b21-b22-b22-b22-b22-....

Alternatively, the hydrophilic group (b2) can also contain at least two types of distributions, e.g., an oligomeric or polymeric segment having a random distribution and an oligomeric or polymeric segment having alternating distribution. Most preferably, the hydrophilic group (b2) preferably has only one type of distribution, and most preferably, said distribution is random or blocklike.

In the embodiments where the hydrophilic group (b2) comprises or consists of the monomer units (b21) and (b22), the molar ratio of (b21) to (b22) can vary broadly and, therefore, can be adjusted most advantageously to the particular requirements of the composition, the process and the use of the invention. Preferably the molar ratio (b21):(b22) is from 100:1 to 1:1, more preferably, from 60:1 to 1.5:1 and, most preferably, from 50:1 to 1.5:1, and particularly preferably, from 25:1 to 1.5:1, and particularly, from 15:1 to 2:1, and for example, from 9:1 to 2:1.

Also the degree of polymerization of the oligomeric and polymeric polyoxyalkylene groups - acting as hydrophilic groups (b2) - can vary broadly and, therefore, can be adjusted most advantageously to the particular requirements of the composition, the process and the use of the invention. Preferably, the degree of polymerization is in the range of from 5 to 100, preferably 5 to 90, and most preferably, 5 to 80.

Particularly, the non-ionic surfactant (B) is an amphiphilic non-ionic polyoxyethylene-polyoxypropylene alkyl ether surfactant which is a mixture of molecules containing, on the average, an alkyl group having 10 to 16 carbon atoms and 5 to 20 oxyethylene monomer units (b21) and 2 to 8 oxypropylene monomer units in random distribution. For example, the non-ionic surfactant (B) is an amphiphilic non-ionic polyoxyethylene-polyoxypropylene alkyl ether surfactant which is a mixture of molecules containing, on the average, an alkyl group having 11 to 14 carbon atoms and 12 to 20 oxyethylene monomer units and 3 to 5 oxypropylene monomer units in random distribution.

The non-ionic surfactant (B) can be contained in varying amounts in the CMP composition (Q). Preferably, the amount of (B) is not more than 10 wt.%, more preferably not more than 3 wt.%, most preferably not more than 1 wt.%, particularly preferably not more than 0.5 wt.%, particularly not more than 0.1 wt.%, for example not more than 0.05 wt.%, based on the total weight of the composition (Q). Preferably, the amount of (B) is at least 0.00001 wt.%, more preferably at least 0.0001 wt.%, most preferably at least 0.0008 wt.%, particularly preferably at least 0.002 wt.%, particularly at least 0.005 wt.%, for example at least 0.008 wt.%, based on the total weight of the composition (Q).

Generally, the non-ionic surfactant (B) can have different weight average molecular weights. The weight average molecular weight of (B) is preferably at least 300, more preferably at least 500, most preferably at least 700, particularly at least 800, for example at least 900. The weight average molecular weight of (B) is preferably not more than 15,000, more preferably not more than 6,000, most preferably not more than 3,000, particularly not more than 2,000, for example not more than 1,400 [g/mol], as determined by gel permeation chromatography (abbreviated as "GPC" in the following). In particular, the weight average molecular weight of (B) is from 900 to 1,400 [g/mol] as determined by GPC. Said GPC are standard GPC techniques known to the person skilled of the art.

In general, the solubility of non-ionic surfactant (B) in an aqueous medium can vary within a wide range. The solubility of (B) in water at pH 7 at 25°C under atmospheric pressure is preferably at least 1 g/L, more preferably at least 5 g/L, most preferably at least 20 g/L, particularly at least 50 g/L, for example at least 150 g/L. Said solubility can be determined by evaporating the solvent and measuring the remaining mass in the saturated solution.

According to the invention, the CMP composition (Q) comprises (C) an aromatic compound comprising at least one acid group (Y), or a salt thereof. In general, any of such aromatic compounds can be used.

The acid group (Y) is defined as being (Y) as such and its deprotonated form. The acid group (Y) comprised in aromatic compound (C) is preferably any acid group so that the pKₐ value (logarithmic measure of the acid dissociation constant) of
the reaction H-(C) ⇄ (C)⁻ + H⁺ or
the reaction [H-(C)]⁺ ⇄ (C) + H⁺
is not more than 7, more preferably not more than 6, most preferably not more than 5.5, particularly preferably not more than 5, as measured in de-ionized water at 25°C and atmospheric pressure.

The acid group (Y) comprised in aromatic compound (C) is preferably a carboxylic acid (-COOH), a carbonic acid (-O-COOH), a sulfonic acid (-SO₃H), a sulfuric acid (-O-SO₃H), a phosphonate (-P(=O)(OH)(OR¹) ), a phosphate (-O-P(=O)(OH)(OR²) ), a phosphonic acid (-P(=O)(OH)₂), a phosphoric acid (-O-P(=O)(OH)₂) moiety, or their deprotonated forms, wherein R¹ is alkyl, aryl, alkylaryl, or arylalkyl, and R² is alkyl, aryl, alkylaryl, or arylalkyl. More preferably, said acid group (Y) is a carboxylic acid (-COOH), or a sulfonic acid (-SO₃H) moiety, or their deprotonated forms. Most preferably, said acid group (Y) is a carboxylic acid (-COOH) moiety, or its deprotonated form.

Preferably, the acid group (Y) is directly covalently bound to the aromatic ring system of the aromatic compound (C).

According to another embodiment, the aromatic compound (C) comprises preferably at least one, more preferably 1 to 2, most preferably exactly one further functional group (Z) which is different from the acid group (Y). The further functional group (Z) can be any functional group other than the acid group (Y), and is
- preferably an ester (-COOR³), hydroxyl, alkoxy, alkyl, aryl, alkylaryl, arylalkyl, nitro, amino, thio, or halogen moiety,
- more preferably an ester (-COOR³), hydroxyl, alkoxy, nitro, amino, thio, or halogen moiety,
- most preferably an ester (-COOR³), nitro, or halogen moiety,
wherein R¹ is alkyl, aryl, alkylaryl, or arylalkyl.

Preferably, the aromatic compound (C)
- comprises per aromatic ring at least two acid groups (Y), or
- comprises per aromatic ring at least one acid group (Y) and at least one further functional group (Z) which is different from acid group (Y).

The aromatic compound (C) comprises at least one, preferably at least two, most preferably 2 to 6, particularly 2 to 4, for example 2 acid groups (Y). The aromatic compound (C) preferably comprises - per aromatic ring - at least one, more preferably at least two, most preferably 2 to 4, for example 2 acid groups (Y).

In one preferred embodiment, the aromatic compound (C) comprises at least one benzene ring, and (C) preferably comprises - per benzene ring - at least one, more preferably at least two, most preferably 2 to 4, for example 2 acid groups (Y).

In a further preferred embodiment, the aromatic compound (C) comprises at least one benzene ring, and (C) preferably comprises - per benzene ring - at least one, more preferably at least two, most preferably 2 to 4, for example 2 carboxylic acid (-COOH) groups or their deprotonated form.

In yet a further preferred embodiment, the aromatic compound (C) is a benzenecarboxylic acid comprising at least one, more preferably at least two, most preferably 2 to 4, for example 2 carboxylic acid (-COOH) groups, or a salt thereof. In yet a further preferred embodiment, the aromatic compound (C) is a benzenecarboxylic acid comprising at least one, more preferably at least two, most preferably 2 to 4, for example 2 carboxylic acid (-COOH) groups which are directly covalently bound to the benzene ring, or a salt thereof. In yet a further preferred embodiment, the aromatic compound (C) is most preferably phthalic acid, terephthalic acid, isophthalic acid, 5-hydroxy-isophthalic acid, benzene-1,2,3-tricarboxylic acid, benzene-1,2,3,4-tetracarboxylic acid, or a derivative thereof, or a salt thereof, particularly terephthalic acid, isophthalic acid, 5-hydroxy-isophthalic acid, benzene-1,2,3,4-tetracarboxylic acid, or a derivative thereof, or a salt thereof, for example terephthalic acid, isophthalic acid or 5-hydroxy-isophthalic acid.

The aromatic compound (C) can be contained in varying amounts in the CMP composition (Q). Preferably, the amount of (C) is not more than 10 wt.%, more preferably not more than 6 wt.%, most preferably not more than 4 wt.%, particularly preferably not more than 3 wt.%, particularly not more than 2 wt.%, for example not more than 1.3 wt.%, based on the total weight of the composition (Q). Preferably, the amount of (C) is at least 0.001 wt.%, more preferably at least 0.01 wt.%, most preferably at least 0.05 wt.%, particularly preferably at least 0.1 wt.%, particularly at least 0.4 wt.%, for example at least 0.7 wt.%, based on the total weight of the composition (Q).

In general, the solubility of the aromatic compound (C) in an aqueous medium can vary within a wide range. The solubility of (C) in water at pH 7 at 25°C under atmospheric pressure is preferably at least 1 g/L, more preferably at least 5 g/L, most preferably at least 20 g/L, particularly at least 50 g/L, for example at least 150 g/L. Said solubility can be determined by evaporating the solvent and measuring the remaining mass in the saturated solution.

According to the invention, the CMP composition (Q) contains an aqueous medium (M). (M) can be of one type or a mixture of different types of aqueous media.

In general, the aqueous medium (M) can be any medium which contains water. Preferably, the aqueous medium (M) is a mixture of water and an organic solvent miscible with water (e.g. an alcohol, preferably a C₁ to C₃ alcohol, or an alkylene glycol derivative). More preferably, the aqueous medium (M) is water. Most preferably, aqueous medium (M) is de-ionized water.

If the amounts of the components other than (M) are in total y % by weight of the CMP composition, then the amount of (M) is (100-y) % by weight of the CMP composition.

The aqueous medium (M) can be contained in varying amounts in the CMP composition (Q). Preferably, the amount of (M) is not more than 99.9 wt.%, more preferably not more than 99.6 wt.%, most preferably not more than 99 wt.%, particularly preferably not more than 98 wt.%, particularly not more than 97 wt.%, for example not more than 95 wt.%, based on the total weight of the composition (Q). Preferably, the amount of (M) is at least 60 wt.%, more preferably at least 70 wt.%, most preferably at least 80 wt.%, particularly preferably at least 85 wt.%, particularly at least 90 wt.%, for example at least 93 wt.%, based on the total weight of the composition (Q).

The CMP composition (Q) can further optionally comprise an alcohol (D). In general, any alcohol can be used as (D). The alcohol (D) is different from the components (A), (B), (C) and (M).

The alcohol (D) is preferably an alcohol having at least two hydroxyl groups which are not dissociable in the aqueous medium. More preferably (D) is an alcohol having two hydroxyl groups which are not dissociable in the aqueous medium. "Not dissociable" means that the pKₐ value (logarithmic measure of the acid dissociation constant) for the reaction
alcohol (D) → deprotonated alcohol (D) + H⁺
of the hydroxyl group in the neutral aqueous phase is more than 9.9, more preferably more than 11, most preferably more than 12, particularly preferably more than 13, for example more than 14 as measured in de-ionized water at 25°C and atmospheric pressure. For example, propane-1,2-diol (alpha-propylene glycol) has a pKₐ value of 14.9 as measured in de-ionized water at 25°C and atmospheric pressure.

More preferably, the alcohol (D) is a diol, triol, tetraol, pentaol, hexaol, heptaol, octaol, nonaol, decaol, or a polyol. Most preferably, (D) is a diol, triol, tetraol, pentaol, or hexaol. Particularly preferably, (D) is a diol. Particularly most preferably, (D) is ethanediol (ethylene glycol), propanediol (propylene glycol), or butanediol (butylene glycol). Particularly, (D) is propanediol (propylene glycol). For example, (D) is propane-1,2-diol (alpha-propylene glycol).

The alcohol (D) is preferably an alcohol having 2 to 50 carbon atoms, more preferably an alcohol having 2 to 20 carbon atoms, most preferably an alcohol having 2 to 11 carbon atoms, particularly preferably an alcohol having 2 to 7 carbon atoms, in particular an alcohol having 2 to 4 carbon atoms, for example an alcohol having 3 carbon atoms.

The alcohol (D) can be contained in varying amounts in the CMP composition (Q). Preferably, the amount of (D) is not more than 10 wt.%, more preferably not more than 5 wt.%, most preferably not more than 3 wt.%, particularly preferably not more than 2 wt.%, particularly not more than 1.2 wt.%, for example not more than 0.8 wt.%, based on the total weight of the composition (Q). Preferably, the amount of (D) is at least 0.001 wt.%, more preferably at least 0.01 wt.%, most preferably at least 0.05 wt.%, particularly preferably at least 0.1 wt.%, particularly at least 0.3 wt.%, for example at least 0.5 wt.%, based on the total weight of the composition (Q).

In general, the solubility of alcohol (D) in an aqueous medium can vary within a wide range. The solubility of (D) in water at pH 7 at 25°C under atmospheric pressure is preferably at least 1 g/L, more preferably at least 5 g/L, most preferably at least 20 g/L, particularly at least 50 g/L, for example at least 150 g/L. Said solubility can be determined by evaporating the solvent and measuring the remaining mass in the saturated solution.

The CMP composition (Q) can further optionally comprise at least one type of oxidizing agent (E), preferably one to two types of oxidizing agent (E), more preferably one type of oxidizing agent (E). The oxidizing agent (E) is different from the components (A), (B), (C) and (M). In general, the oxidizing agent is a compound which is capable of oxidizing the to-be-polished substrate or one of its layers. Preferably, (E) is a per-type oxidizer. More preferably, (E) is a peroxide, persulfate, perchlorate, perbromate, periodate, permanganate, or a derivative thereof. Most preferably, (E) is a peroxide or persulfate. Particularly, (E) is a peroxide. For example, (E) is hydrogen peroxide.

If present, the oxidizing agent (E) can be contained in varying amounts in the CMP composition (Q). Preferably, the amount of (E) is not more than 20 wt.%, more preferably not more than 10 wt.%, most preferably not more than 5 wt.%, particularly not more than 2.5 wt.%, for example not more than 1.5 wt.%, based on the total weight of the composition (Q). Preferably, the amount of (E) is at least 0.01 wt.%, more preferably at least 0.08 wt.%, most preferably at least 0.4 wt.%, particularly at least 0.75 wt.%, for example at least 1 wt.%, based on the total weight of the composition (Q). If hydrogen peroxide is used as oxidizing agent (E), the amount of (E) is preferably 0.5 wt.% to 4 wt.%, more preferably 1 wt.% to 2 wt.%, for instance 1.2 to 1.3 wt.%, based on the total weight of the composition (Q).

The CMP composition (Q) can further optionally contain at least one corrosion inhibitor (F), for example one corrosion inhibitor. The corrosion inhibitor (F) is different from the components (A), (B), (C) and (M). In general, all compounds forming a protective molecular layer on the surface of a metal - for example copper - can be used as corrosion inhibitor. Preferred corrosion inhibitors (F) are thiols, film forming polymers, polyols, diazoles, triazoles, tetrazoles, and their derivatives, most preferably imidazole, 1,2,4-triazole, benzotriazole, tolyltriazole, and derivatives thereof, for example benzotriazole.

If present, the corrosion inhibitor (F) can be contained in varying amounts. If present, the amount of (F) is preferably not more than 10 wt.%, more preferably not more than 2 wt.%, most preferably not more than 0.5 wt.%, particularly not more than 0.15 wt.%, for example not more than 0.04 wt.%, based on the total weight of the corresponding composition. If present, the amount of (F) is preferably at least 0.0001 wt.%, more preferably at least 0.001 wt.%, most preferably at least 0.005 wt.%, particularly at least 0.01 wt.%, for example at least 0.02 wt.%, based on the total weight of the corresponding composition (Q).

The CMP composition (Q) can further optionally contain at least one chelating agent (G), preferably one chelating agent (G). In general, a chelating agent used in a CMP composition is a chemical compound that forms soluble, complex molecules with certain metal ions, inactivating the ions so that they cannot normally react with other elements or ions to produce precipitates or scale. The chelating agent (G) is different from the components (A), (B), (C) and (M).

If present, the chelating agent (G) can be contained in varying amounts. If present, the amount of (G) is preferably not more than 10 wt.%, more preferably not more than 5 wt.%, most preferably not more than 3 wt.%, particularly not more than 2 wt.%, for example not more than 1.5 wt.%, based on the total weight of the corresponding composition. If present, the amount of (G) is preferably at least 0.001 wt.%, more preferably at least 0.01 wt.%, most preferably at least 0.07 wt.%, particularly at least 0.2 wt.%, for example at least 0.7 wt.%, based on the total weight of the corresponding composition (Q).

Preferably, the chelating agent (G) is an inorganic or organic acid. More preferably, the chelating agent (G) is a compound comprising at least two carboxylic acid (-COOH) or carboxylate (-COO-) groups. Most preferably, the chelating agent (G) is selected from the group consisting of malonic acid, citric acid, acetic acid, adipic acid, butyric acid, glutaric acid, glycolic acid, formic acid, fumaric acid, lactic acid, lauric acid, malic acid, maleic acid, myristic acid, oxalic acid, palmitic acid, propionic acid, pyruvic acid, stearic acid, succinic acid, tartaric acid, valeric acid, 2-methylburyric acid, n-hexanoic acid, 3,3-dimethylbutyric acid, 2-ethylbutyric acid, 4-methylpentanoic acid, n-heptanoic acid, 2-methylhexanoic acid, n-octanoic acid, 2-ethylhexanoic acid, propane-1,2,3-tricarboxylic acid, butane-1,2,3,4-tetracarboxylic acid, pentane-1,2,3,4,5-pentacarboxylic acid, trimellitic acid, trimesinic acid, pyromellitic acid, mellitic acid, and an oligomeric or polymeric polycarboxylic acid. Particularly preferably, (G) is selected from the group consisting of malonic acid, citric acid, adipic acid, propane-1,2,3-tricarboxylic acid, butane-1,2,3,4-tetracarboxylic acid, and pentane-1,2,3,4,5-pentacarboxylic acid. Particularly, (G) is selected from the group consisting of malonic acid and citric acid. For example, (G) is malonic acid.

The properties of the CMP composition (Q), such as stability and polishing performance, may depend on the pH of the corresponding composition. In general, the CMP composition (Q) can have any pH value. The pH value of the composition (Q) is preferably not more than 14, more preferably not more than 13, most preferably not more than 12, particularly preferably not more than 11.5, particularly most preferably not more than 11, particularly not more than 10.5, for example not more than 10.2. The pH value of the composition (Q) is preferably at least 6, more preferably at least 7, most preferably at least 8, particularly preferably at least 8.5, particularly most preferably at least 9, particularly at least 9.5, for example at least 9.7. The pH value of the composition (Q) is preferably in the range of from 6 to 14, more preferably from 7 to 13, most preferably from 8 to 12, particularly preferably from 8.5 to 11.5, particularly most preferably from 9 to 11, particularly from 9.5 to 10.5, for example from 9.7 to 10.2.

The CMP composition (Q) can further optionally contain at least one pH adjusting agent (H). The pH adjusting agent (H) is different from the components (A), (B), (C) and (M). In general, the pH adjusting agent (H) is a compound which is added to the CMP composition (Q) to have its pH value adjusted to the required value. Preferably, the CMP composition (Q) contains at least one pH adjusting agent (H). Preferred pH adjusting agents are inorganic acids, carboxylic acids, amine bases, alkali hydroxides, ammonium hydroxides, including tetraalkylammonium hydroxides. Particularly, the pH adjusting agent (H) is nitric acid, sulfuric acid, ammonia, sodium hydroxide, or potassium hydroxide. For example, the pH adjusting agent (H) is potassium hydroxide.

If present, the pH adjusting agent (H) can be contained in varying amounts. If present, the amount of (H) is preferably not more than 10 wt.%, more preferably not more than 2 wt.%, most preferably not more than 0.5 wt.%, particularly not more than 0.1 wt.%, for example not more than 0.05 wt.%, based on the total weight of the corresponding composition. If present, the amount of (H) is preferably at least 0.0005 wt.%, more preferably at least 0.005 wt.%, most preferably at least 0.025 wt.%, particularly at least 0.1 wt.%, for example at least 0.4 wt.%, based on the total weight of the corresponding composition (Q).

The CMP composition (Q) can further optionally contain at least one biocide (J), for example one biocide. The biocide (J) is different from the components (A), (B), (C) and (M). In general, the biocide is a compound which deters, renders harmless, or exerts a controlling effect on any harmful organism by chemical or biological means. Preferably, (J) is an quaternary ammonium compound, an isothiazolinone-based compound, an N-substituted diazenium dioxide, or an N'-hydroxy-diazenium oxide salt. More preferably, (J) is an N-substituted diazenium dioxide, or an N'-hydroxy-diazenium oxide salt

If present, the biocide (J) can be contained in varying amounts. If present, the amount of (J) is preferably not more than 0.5 wt.%, more preferably not more than 0.1 wt.%, most preferably not more than 0.05 wt.%, particularly not more than 0.02 wt.%, for example not more than 0.008 wt.%, based on the total weight of the corresponding composition. If present, the amount of (J) is preferably at least 0.0001 wt.%, more preferably at least 0.0005 wt.%, most preferably at least 0.001 wt.%, particularly at least 0.003 wt.%, for example at least 0.006 wt.%, based on the total weight of the corresponding composition (Q).

The CMP composition (Q) may also contain, if necessary, at least one other additive, including but not limited to stabilizers, friction reducing agents, etc. Said other additive is different from the components (A), (B), (C) and (M). Said other additives are for instance those commonly employed in CMP compositions and thus known to the person skilled in the art. Such addition can for example stabilize the dispersion, or improve the polishing performance, or the selectivity between different layers.

If present, said other additive can be contained in varying amounts. If present, the total amount of said other additives is preferably not more than 10 wt.%, more preferably not more than 2 wt.%, most preferably not more than 0.5 wt.%, particularly not more than 0.1 wt.%, for example not more than 0.01 wt.%, based on the total weight of the corresponding CMP composition. If present, the total amount of said other additives is preferably at least 0.0001 wt.%, more preferably at least 0.001 wt.%, most preferably at least 0.008 wt.%, particularly at least 0.05 wt.%, for example at least 0.3 wt.%, based on the total weight of the corresponding composition (Q).

According to the preferred embodiment (PE1), the composition (Q) comprises
(A) silica particles,
(B) an amphiphilic non-ionic surfactant comprising a polyoxyalkylene group,
(C) an aromatic compound which
   - comprises per aromatic ring at least two acid groups (Y), or
   - comprises per aromatic ring at least one acid group (Y) and at least one further functional group (Z) which is different from acid group (Y),
      or a salt of this aromatic compound, and
(M) an aqueous medium.

According to the preferred embodiment (PE2), the composition (Q) comprises
(A) silica particles,
(B) an amphiphilic non-ionic surfactant comprising a polyoxyalkylene group,
(C) an aromatic compound which comprises at least one benzene ring and comprises per benzene ring at least one carboxylic acid (-COOH) group or its deprotonated form, and
(M) an aqueous medium.

According to the preferred embodiment (PE3), the composition (Q) comprises
(A) silica particles,
(B) an amphiphilic non-ionic surfactant comprising a polyoxyalkylene group,
(C) an aromatic compound comprising at least one acid group (Y), or a salt thereof,
(D) an alcohol,
(E) an oxidizing agent,
(F) a corrosion inhibitor, and
(M) an aqueous medium.

According to the preferred embodiment (PE4), the composition (Q) comprises
(A) silica particles,
(B) an amphiphilic non-ionic surfactant comprising a polyoxyalkylene group,
(C) a benzenecarboxylic acid comprising at least two carboxylic groups (-COOH), or a salt thereof,
(D) an alcohol having at least two hydroxyl groups which are not dissociable in the aqueous medium,
(E) an oxidizing agent,
(F) a corrosion inhibitor, and
(M) an aqueous medium.

Processes for preparing CMP compositions are generally known. These processes may be applied to the preparation of the CMP composition (Q). This can be carried out by dispersing or dissolving the above-described components (A), (B), (C) and optionally other components in the aqueous medium (M), preferably water, and optionally by adjusting the pH value through adding an acid, a base, a buffer or an pH adjusting agent. Particularly preferably, the CMP composition (Q) can be prepared by mixing an aqueous dispersion comprising not less than 6 wt. % particles (A), for example silica, an aqueous dispersion comprising not less than 1 wt.% non-ionic surfactant (B), 5 wt. % aromatic compound (C) and diluting with de-ionized water. For this purpose, the customary and standard mixing processes and mixing apparatuses such as agitated vessels, high shear impellers, ultrasonic mixers, homogenizer nozzles or counterflow mixers, can be used.

The CMP composition (Q) is preferably prepared by dispersing the particles (A), dispersing and/or dissolving the non-ionic surfactant (B), the aromatic compound (C) and optionally other additives in the aqueous medium (M).

The polishing process is generally known and can be carried out with the processes and the equipment under the conditions customarily used for the CMP in the fabrication of wafers with integrated circuits. There is no restriction on the equipment with which the polishing process can be carried out.

As is known in the art, typical equipment for the CMP process consists of a rotating platen which is covered with a polishing pad. Also orbital polishers have been used. The wafer is mounted on a carrier or chuck. The side of the wafer being processed is facing the polishing pad (single side polishing process). A retaining ring secures the wafer in the horizontal position. Below the carrier, the larger diameter platen is also generally horizontally positioned and presents a surface parallel to that of the wafer to be polished. The polishing pad on the platen contacts the wafer surface during the planarization process.

To produce material loss, the wafer is pressed onto the polishing pad. Both the carrier and the platen are usually caused to rotate around their respective shafts extending perpendicular from the carrier and the platen. The rotating carrier shaft may remain fixed in position relative to the rotating platen or may oscillate horizontally relative to the platen. The direction of rotation of the carrier is typically, though not necessarily, the same as that of the platen. The speeds of rotation for the carrier and the platen are generally, though not necessarily, set at different values. During the CMP process of the invention, the CMP composition (Q) is usually applied onto the polishing pad as a continuous stream or in dropwise fashion. Customarily, the temperature of the platen is set at temperatures of from 10 to 70°C.

The load on the wafer can be applied by a flat plate made of steel for example, covered with a soft pad that is often called backing film. If more advanced equipment is being used a flexible membrane that is loaded with air or nitrogen pressure presses the wafer onto the pad. Such a membrane carrier is preferred for low down force processes when a hard polishing pad is used, because the down pressure distribution on the wafer is more uniform compared to that of a carrier with a hard platen design. Carriers with the option to control the pressure distribution on the wafer may also be used according to the invention. They are usually designed with a number of different chambers that can be loaded to a certain degree independently from each other.

For further details reference is made to WO 2004/063301 A1, in particular page 16, paragraph [0036] to page 18, paragraph [0040] in conjunction with the figure 2.

By way of the CMP process of the invention, wafers with integrated circuits comprising a dielectric layer can be obtained which have an excellent functionality.

The CMP composition (Q) can be used in the CMP process as ready-to-use slurry, they have a long shelf-life and show a stable particle size distribution over long time. Thus, they are easy to handle and to store. They show an excellent polishing performance, particularly with regard to (a') high MRR of tantalum nitride, (b') low MRR of copper layer, (c') low MRR of low-k or ultra-low-k materials, (d') high selectivity of tantalum nitride over copper with regard to MRR, and (e') high selectivity of tantalum nitride over low-k or ultra-low-k materials with regard to MRR. Furthermore, the CMP composition of the invention shows a longer shelf life, agglomeration within the CMP composition of the invention can be avoided, while high MRR of barrier layer was maintained. Since the amounts of its components are held down to a minimum, the CMP composition (Q) and the CMP process according to the invention can be used or applied in a cost-effective way.

### Examples and Comparative Examples

### General procedure for the CMP experiments

For the evaluation of the polishing performance on the polisher, the following parameters were chosen:

Polisher: Strasbaugh nSpire (Model 6EC), ViPRR floating retaining ring carrier (hard platen design);

| | |
|---|---|
| down pressure: | 2.0 psi (140 mbar); |
| back side pressure: | 1.5 psi (100 mbar); |
| retaining ring pressure: | 3.0 psi (210 mbar); |
| polishing table / carrier speed: | 112 / 115 rpm; |
| slurry flow rate: | 200 ml / min; |
| time main polishing step: | 60 s; |
| pad conditioning: | ex situ (2 Ibs (=0.907 kg), 8.9 N); |
| rinse: | 10 sec. water |
| | |
| polishing pad: | Fujibo H800 NW; |
| backing film: | Strasbaugh, DF200 (136 holes); |
| conditioning disk: | Diamonex CMP 4S830CF6; |

The pad is conditioned by two sweeps, before a new type of slurry is used for CMP. The slurry is stirred in the local supply station.

Standard analysis procedure for (semi) transparent blanket wafers:

Removal rate is determined by Filmmetrics F50 reflectometer as mean of diffential 49 point diameter scan (5 mm ee) pre and post CMP.

The radial non-unifomity of removal rate is assessed by relative standard deviation of differential 49 point diameter scan pre and post CMP using Filmmetrics F50 (5 mm ee).

Standard consumables for CMP of (semi) transparent coated wafers at

| | |
|---|---|
| SiO₂ films: | plasma-enhanced tetraethyl orthosilicate (referred to as "PETEOS" in the following); |
| Tantalum nitride: | CVD; |
| Low k material: | black diamond 1^{st} generation (referred to as "BD1" in the following); |
| Copper: | electro plated; |

Evaluation of the stock removal rate was carried out by means of a 8 inch (=20.32 cm) blanket wafer. The layer thickness before and after 60 seconds of polishing is measured by a sheet resistance meter (Resmap 273, manufactured by Creative Design Engineering, Inc.).

### Dispersion stability test:

200 mL slurry were put in an oven and stored for 14 days at 60°C, pH and mean particle size were measured in dependence of the time.

| | |
|---|---|
| pH: | Knick Portamess 911xpH, electrode: Schott instruments Blue Line 28 pH |
| Calibration: | Bernd Kraft GmbH (pH4 - Art.Nr. 03083.3000 and pH7 - Art.Nr. 03086.3000) |
| mean particle size: | Malvern Instruments GmbH, HPPS 5001 |

Silica particles used as particles (A) are of Fuso PL-3 type. Fuso PL-3 are cocoon-shaped colloidal silica particles having an average primary particle size (d1) of 35 nm and an average secondary particle size (d2) of 70 nm.

(B1) is an amphiphilic non-ionic polyoxyethylene-polyoxypropylene alkyl ether surfactant which is a mixture of molecules containing, on the average, an alkyl group having 11 to 14 carbon atoms and 12 to 20 oxyethylene monomer units and 3 to 5 oxypropylene monomer units in random distribution. The weight average molecular weight of (B1) is from 900 to 1,500 [g/mol].

### Procedure for slurry preparation:

Preparation of 500 g of the compositions of the Examples 1 to 4 and of the Comparative Examples V1 and V2:

5.00 g chelating agent (G) or aromatic compound (C) are dissolved in 380 g water (M), followed by the slow addition of 3.21 g alcohol (D), 0.50 g nonionic surfactant (B) (10 wt.% aqueous solution) and 12.5 g corrosion inhibitor (F) (1 wt.% aqueous solution). KOH is used to adjust the pH to 10.5, followed by the addition of 20.0 g of the abrasive particles (A) (20 wt.% aqueous dispersion). Water is added to yield 480 g, pH is adjusted again to 10.5 and monitored for 1 h. 20.0 g of oxidizer (E) (31 wt.% aqueous solution) is added prior to polishing, and the pH values as indicated in Table 1 are obtained.

The final CMP composition contains the components (A), (B), (C), (D), (E), (F) and optionally (G) or other additives in the amounts as indicated in Table 1.

### Examples 1 to 4 (Compositions according to the invention) and Comparative Examples V1 and V2 (comparative composition)

An aqueous dispersion containing the components as listed in Table 1 was prepared, furnishing the CMP compositions of the Examples 1 to 4 and the comparative example V1 and V2.

The formulation and polishing performance data of the CMP compositions of the Example 1 to 4 and of the comparative examples V1 and V2 are indicated in the Table 1:

**Table 1: CMP compositions of the examples 1 to 4 and of the comparative examples V1 and V2, their pH values, MRR data and dispersion stability data in the process of chemical-mechanical polishing of 8 inch (=20.32 cm) blanket wafers using these compositions, wherein the aqueous medium (M) of the CMP compositions is de-ionized water. The amounts of the components (A), (B), (C), (D), (E), (F) and optionally (G) or other additives are specified in weight percent (wt.%) by weight of the corresponding CMP composition. If the amounts of the components other than (M) are in total y % by weight of the CMP composition, then the amount of (M) is (100-y) % by weight of the CMP composition. The pH of the compositions is adjusted using potassium hydroxide.**

| | Comparative Example V1 | Comparative Example V2 | Example 1 | Example 2 | Example 3 | Example 4 |
|---|---|---|---|---|---|---|
| Particles (A) | Fuso PL-3 silica 2 wt. % | Fuso PL-3 silica 2 wt. % | Fuso PL-3 silica 2 wt. % | Fuso PL-3 silica 2 wt. % | Fuso PL-3 silica 2 wt. % | Fuso PL-3 silica 2 wt. % |
| Non-ionic surfactant (B) | (B1) 0.01 wt.% | (B1) 0.01 wt.% | (B1) 0.01 wt.% | (B1) 0.01 wt.% | (B1) 0.01 wt.% | (B1) 0.01 wt.% |
| Aromatic compound (C) | - | - | Terephthalic acid 1 wt.% | Benzene-1,2,3,4-tetracar-boxylic acid 1 wt.% | Isophthalic acid 1 wt.% | 5-hydroxyisophthalic acid 1 wt.% |
| Alcohol (D) | propane-1,2-diol 0.65 wt.% | propane-1,2-diol 0.65 wt.% | propane-1,2-diol 0.65 wt.% | propane-1,2-diol 0.65 wt.% | propane-1,2-diol 0.65 wt.% | propane-1,2-diol 0.65 wt.% |
| Oxidizing agent (E) | H₂O₂ 1.24 wt. % | H₂O₂ 1.24 wt. % | H₂O₂ 1.24 wt. % | H₂O₂ 1.24 wt. % | H₂O₂ 1.24 wt. % | H₂O₂ 1.24 wt. % |
| Corrosion inhibitor (F) | Benzotriazole 0.025wt.% | Benzotriazole 0.025 wt. % | Benzotriazole 0.025 wt. % | Benzotriazole 0.025 wt. % | Benzotriazole 0.025 wt. % | Benzotriazole 0.05 wt. % |
| Chelating agent (G) | Acetic Acid 1 wt.% | Malonic Acid 1 wt.% | - | - | - | - |
| pH | 9.6 | 9.6 | 9.6 | 9.6 | 9.6 | 9.9 |
| PETEOS-MRR in Å/min | 461 | 473 | 350 | 399 | 382 | 442 |
| Tantalum nitride MRR in Å/min | 824 | 782 | 723 | 783 | 746 | 792 |
| Copper MRR in Å/min | 122 | 187 | 111 | 110 | 139 | 157 |
| BD1 MRR in Å/min | 108 | 82 | 38 | 59 | 64 | 109 |
| Result of the dispersion stability test | instable | instable | stable | stable | stable | stable |

**Table 2: Mean particle size (as measured with dynamic light scattering techniques, e.g. Malvern Instruments GmbH, HPPS 5001) of the CMP compositions of the examples 1 to 4 and of the comparative examples V1 and V2 over time at accelerated rate (60°C)**

| Duration of storage for the dispersion stability test, in days | Comparative Example V1 | Comparative Example V2 | Example 1 | Example 2 | Example 3 | Example 4 |
|---|---|---|---|---|---|---|
| 0 | 66 | 66 | 66 | 66 | 66 | 67 |
| 1 | 67 | 67 | 66 | 66 | 66 | 67 |
| 4 | 72 | 73 | 67 | 67 | 67 | 67 |
| 7 | 78 | 80 | 67 | 67 | 67 | 67 |
| 11 | 87 | 88 | 67 | 67 | 67 | 67 |
| 14 | 96 | 95 | 67 | 67 | 67 | 67 |
| Result of the dispersion stability test after 14 days | instable | instable | stable | stable | stable | stable |

The CMP compositions of the Examples 1 to 4 show an improved polishing performance and improved shelf life, particularly shows high MRR of tantalum nitride, high selectivity of tantalum nitride over copper with regard to MRR, and high selectivity of tantalum nitride over black diamond 1^{st} generation material with regard to MRR.

## Claims

1. A chemical mechanical polishing (CMP) composition (Q) comprising
(A) inorganic particles, organic particles, or a mixture or composite thereof,
(B) a non-ionic surfactant,
(C) an aromatic compound comprising at least one acid group (Y), or a salt thereof, and
(M) an aqueous medium.

2. The CMP composition according to claim 1, wherein the aromatic compound (C)
- comprises per aromatic ring at least two acid groups (Y), or
- comprises per aromatic ring at least one acid group (Y) and at least one further functional group (Z) which is different from acid group (Y).

3. The CMP composition according to claim 1, wherein the aromatic compound (C) comprises at least one benzene ring and comprises per benzene ring at least one carboxylic acid (-COOH) group or its deprotonated form.

4. The CMP composition according to claim 1, wherein the aromatic compound (C) is a benzenecarboxylic acid comprising at least two carboxylic acid (-COOH) groups, or a salt thereof.

5. The CMP composition according to anyone of the claims 1 to 4, wherein the CMP composition (Q) further comprises (E) an oxidizing agent.

6. The CMP composition according to anyone of the claims 1 to 5, wherein the CMP composition (Q) further comprises (D) an alcohol.

7. The CMP composition according to anyone of the claims 1 to 6, wherein the CMP composition (Q) further comprises (F) a corrosion inhibitor.

8. The CMP composition according to anyone of the claims 1 to 7, wherein the particles (A) are silica particles.

9. The CMP composition according to anyone of the claims 1 to 8, wherein the particles (A) are cocoon-shaped silica particles.

10. The CMP composition according to anyone of the claims 1 to 9, wherein the non-ionic surfactant (B) is an amphiphilic non-ionic surfactant comprising a polyoxyalkylene group.

11. The CMP composition according to anyone of the claims 1 to 10, wherein the pH value of the composition is in the range of from 8 to 12.

12. The CMP composition according to anyone of the claims 1 to 11, wherein the CMP composition (Q) comprises
(A) silica particles,
(B) an amphiphilic non-ionic surfactant containing a polyoxyalkylene group,
(C) a benzenecarboxylic acid comprising at least two carboxylic groups (-COOH), or a salt thereof,
(D) an alcohol having at least two hydroxyl groups which are not dissociable in the aqueous medium,
(E) an oxidizing agent,
(F) a corrosion inhibitor, and
(M) an aqueous medium.

13. A process for the manufacture of semiconductor devices comprising the chemical mechanical polishing of a substrate (S) in the presence of a CMP composition as defined in anyone of the claims 1 to 12.

14. Use of a CMP composition as defined in anyone of the claims 1 to 12 for chemical mechanical polishing of a substrate (S) used in the semiconductor industry.

15. Use according to claim 14, wherein the substrate (S) comprises
(i) copper, and/or
(ii) tantalum, tantalum nitride, titanium, titanium nitride, ruthenium, cobalt, or alloys thereof.
